# EUROPÄISCHE PATENTANMELDUNG

(11) **EP 2 782 131 A2**
(43) Veröffentlichungstag der Anmeldung: **24.09.2014**
(21) Anmeldenummer: 14154241.5
(22) Anmeldetag: 07.02.2014
(51) Int. Cl.: H01L 23/053, H01L 23/00

(54) **Leistungshalbleitermodul und Anordnung hiermit**

(30) Priorität: 20.03.2013 DE 102013102829
(71) Anmelder: SEMIKRON Elektronik GmbH & Co. KG, 90431 Nürnberg (DE)
(72) Erfinder: Hansen, Jürgen, 90513 Zirndorf (DE); Tursky, Werner, 92224 Amberg (DE)

(57) **Zusammenfassung**

Es wird eine Anordnung und ein hermetisch dichtes Leistungshalbleitermodul hierfür vorgestellt, mit einem Substrat, einem Gehäuse und Anschlusselementen für Last- und Hilfsanschlüsse. Hierbei weist das Substrat eine metallische Grundplatte auf, auf deren dem Modulinneren zugewandten Hauptfläche ein Isolierstoffkörper mit Leiterbahnen und mindestens einem hierauf angeordnetem Leistungshalbleiterbauelement sowie modulinterne Verbindungseinrichtungen angeordnet sind. Weiterhin ist das Gehäuse aus einem hermetisch dichten Werkstoff ausgebildet ist und mit dem Substrat mittels eines elastischen, hermetisch dicht schließenden ersten Verbindungsmittels verbunden. Die Last- und Hilfsanschlusselemente führen hierbei von der leistungselektrischen Schaltung des Substrats nach außen durch das Gehäuse, wobei diese Durchführung hermetisch dicht ausgebildet ist.

## Beschreibung

Die Erfindung beschreibt ein Leistungshalbleitermodul und eine Anordnung hiermit das für besonders hohe Leistungsdichten und raue Umgebungsbedingungen geeignet ist.

Den Stand der Technik bilden einerseits Leistungshalbleitermodule in Form von langjährig bekannten Scheibenzellen. Die DE 101 32 169 A1 offenbart eine fachübliche Ausgestaltung derartiger Scheibenzellen. Diese weisen ein Gehäuse aus einem meist keramischen Isolierstoff auf, wobei das Gehäuse einen zylindermantelförmig ausgebildet Gehäuseteil aufweist, der fachüblich meist nur ein Leistungshalbleiterbauelement umschließt. Die beiden Deckflächen des Gehäuse sind gleichzeitig als Kontakteinrichtungen zur Lastverbindung des Leistungshalbleiterbauelement ausgebildet. Gegebenenfalls notwendige Hilfsanschlüsse, meist als Steueranschluss zur Ansteuerung des Leistungshalbleiterbauelement ausgebildet, werden durch Durchführungen des zylindermantelförmigen Gehäuseteils geführt. Derartige Scheibenzellen werden fachüblich mit mindestens einer Kontakteinrichtung auf einem Kühlkörper angeordnet, wobei im Betrieb der Scheibenzelle dieser Kühlkörper somit das elektrische Potential dieser Kontakteinrichtung aufweist.

Der Stand der Technik, beispielhaft bekannt aus der DE10 2005 055 713 oder auch der DE 10 2010 038 723 A1, wird weiterhin gebildet durch sog. isolierte Leistungshalbleitermodule, die sich insbesondere dadurch von den oben genannten Scheibenzellen unterscheiden, dass ein zugeordneter Kühlkörper nicht auf einem der elektrischen Potentiale einer Lastanschlusseinrichtung, sondern in der Regel auf Grundpotential, liegt. Hierzu weisen derartige Leistungshalbleitermodule eine innere Isolierung der Lastpotentiale zur Kühleinrichtung auf, wobei hierzu ein isolierendes Substrat meist mit einer Mehrzahl von Leiterbahnen vorgesehen ist. Häufig wiesen derartige isolierte Leistungshalbleitermodule eine Mehrzahl von Leistungshalbleiterbauelement auf, die eine leistungselektronische Schaltung ausbilden. Fachüblich weisen isolierte Leistungshalbleitermodule ein die leistungselektronische Schaltung umschließendes, häufig becherartiges Kunststoffgehäuse auf. Dieses Kunststoffgehäuse ist zur inneren elektrischen Isolierung der leistungselektronischen Schaltung teilweise mit einer Vergussmasse befüllt.

Die genannte isolierten Leistungshalbleiermodule lassen sich weiterhin in zwei Klassen einteilen. Einerseits diejenigen Leistungshalbleitermodule mit einer Grundplatte, die meist aus Kupfer ausgebildet ist und im Inneren des Leistungshalbleitermoduls das Substrat trägt. Bei diesen Leistungshalbleitermoduls sind das becherartige Gehäuse und die Bodenplatte stoffschlüssig fest mit einander verbunden, so dass es im Betrieb zu thermomechanischen Spannungen und thermomechanischen Bewegungen der verschiedenen Komponenten des Moduls kommt. Fachüblich werden diese Leistungshalbleitermodule mit durch die Grundplatte hindurchreichende Schrauben und mit hohe Anzugsmomenten auf der Kühlverrichtung fixiert.

Die zweite Klasse der isolierten Leistungshalbleitermodule weisen keine eigenen Grundplatte auf. Vielmehr ist hier das Substrats bei der Verwendung in direktem Kontakt mit einem Kühlkörper. Die Verbindung zwischen dem Substrat und dem becherartigen Gehäuse erfolgt hier fachüblich mittels stoffschlüssiger, aber elastischer Klebeverbindungen, häufig auf Silikonbasis.

Fachüblich weisen die isolierten Leistungshalbleitermodule keine Abdichtung der Anschlusselemente für Last- und der Hilfsanschlüsse gegen Umwelteinflüsse auf.

In fachüblicher Weise ist nur die erste genannten Variante, die nicht isolierten Leistungshalbleitermodule also üblicherweise die Scheibenzellen, hermetisch dicht und somit gegen Umweltbedingungen geschützt. Hierbei können in hermetisch dichten Leistungshalbleitermodul Abdichtungen derart ausgebildet sein dass diese Abdichtungen gegen Umwelteinflüsse starr, beispielhaft mittels Glaslot oder mittels einer Hartlötverbindung, ggf. in Kombination mit einer Schweißverbindung, ausgebildet sind. Insbesondere in modernen Anwendungen von Leistungshalbleitermodulen insbesondere in Fahrzeugen kommt einem Schutz gegen Staub, Wasser und Öl eine immer bedeutendere Rolle zu. Auch weisen insbesondere die isolierten Leistungshalbleitermodule durch steigende Leistungsdichten ebenso steigende thermomechanische Beanspruchungen im Betrieb auf. Derartige Beanspruchungen können über die Lebenszeit zu einem Ausfall des frühen Ausfall des Leistungshalbleitermoduls führen.

In Kenntnis dieser Gegebenheiten liegt der Erfindung die Aufgabe zugrunde, ein qualitativ besonders hochwertiges Leistungshalbleitermodul und eine Anordnung hiermit vorzustellen das hermetisch dicht ausgebildete ist und die Einkopplung äußerer Kräfte auf die Schaltungselemente, insbesondere die Leistungshalbleiterbauelemente und deren Verbindungen zum Substrat, minimiert. Diese Verbindungen sind insbesondere auch die elektrisch leitenden Verbindungen.

Diese Aufgabe wird erfindungsgemäß gelöst durch ein Leistungshalbleitermodul mit den Merkmalen des Anspruchs 1, sowie durch eine Anordnung mit einem derartigen Leistungshalbleitermodul mit den Merkmalen des Anspruchs 10. Bevorzugte Ausführungsformen sind in den jeweiligen abhängigen Ansprüchen beschrieben.

Das erfindungsgemäße Leistungshalbleitermodul ist ausgebildet als ein hermetisch dichtes Leistungshalbleitermodul mit einem Substrat, einem vorzugsweise elektrisch isolierend ausgebildeten Gehäuse und Anschlusselementen für Last- und Hilfsanschlüsse. Hierbei weist das Substrat eine metallische Grundplatte auf, auf derer dem modulinneren zugewandten Hauptfläche ein Isolierstoffkörper mit Leiterbahnen und mindestens einem hierauf angeordnetem Leistungshalbleiterbauelement sowie modulinterne Verbindungseinrichtungen vorgesehen sind. Die Anordnung des Isolierstoffkörpers auf der Grundplatte erfolgt vorzugsweise mittels dünner metallischer Zwischenschichten.

Weiterhin ist das Gehäuse aus einem hermetisch dichten Werkstoff ausgebildet und mit dem Substrat mittels eines elastischen, hermetisch dicht schließenden ersten Verbindungsmittels verbunden. Hierbei führen die Anschlusselementen für Last- und Hilfsanschlüsse des Leistungshalbleitermoduls nach außen durch das Gehäuse hindurch, wobei diese Durchführung hermetisch dicht ausgebildet ist.

Unter "hermetisch dicht" soll im Sinne dieser Druckschrift eine Schutzklasse von mindestens IP65, vorzugsweise IP67, gemäß der europäischen Norm EN 60529 verstanden werden.

Das Verbindungsmittel zwischen Gehäuse und Grundplatte bzw. Kühleinrichtung soll insbesondere eine Federkonstante von einigen Newton pro Millimeter Auslenkung, speziell zwischen 1 und 10 N/mm, insbesondere zwischen 2 und 5 N/mm, und eine Kantenlänge zwischen den Verbindungspartner in der Größenordnung von Zentimetern, insbesondere mit einer Kantenlänge von 2mm bis 2cm, aufweisen.

Es ist bevorzugt wenn die Grundplatte des Leistungshalbleitermoduls auf ihrer dem Modulinneren abgewandten Seite Kühlelemente, insbesondere Kühlfinger oder Kühlfinnen, aufweist.

Vorteilhafterweise ist der elektrische Isolierstoffkörper des Leistungshalbleitermoduls aus einem Material guter Wärmeleitfähigkeit, insbesondere aus Aluminiumoxid oder Aluminiumnitrid, ausgebildet.

Das Gehäuse des Leistungshalbleitermoduls ist in bevorzugter Weise aus Metall, aus Keramik oder aus Glaskeramik oder geeigneten Kombinationen hieraus ausgebildet.

Das erste elastische Verbindungsmittel des Leistungshalbleitermoduls besteht vorteilhafterweise aus einem Material, insbesondere einer Legierung, hoher Biegezyklenfestigkeit. Bekannte Legierungen aus Kupfer und Chrom (CuCr) erfüllen diese Anforderungen. Weiterhin, insbesondere im Fall der genannten Legierung, kann es vorteilhaft sein, wenn das erste elastische Verbindungsmittel mit einem Schutzüberzug, insbesondere gegen korrosive Medien, beschichtet ist.

Der gesamte Innenraum des Leistungshalbleitermoduls ist in bevorzugter Weise mittels eines Isolierstoffes in flüssiger oder gelartiger Ausgestaltung ausgefüllt. Dieser Isolierstoff kann Trafoöl oder fachüblicher Weichverguss auf Silikonbasis sein. Der Isolierstoff dient maßgeblich der inneren Isolation des Leistungshalbleitermoduls bzw. der internen Schaltung, kann aber alternativ oder gleichzeitig auf der verbesserten thermischen Verteilung im Inneren des Leistungshalbleitermoduls dienen.

Die Durchführung der Anschlusselemente der Last- und Hilfsanschlüsse ist bevorzugt als Glaslotdurchführung ausgebildet ist. In Korrelation hierzu ist es ebenso bevorzugt, wenn die Anschlusselement in ihrem Verlauf im Inneren des Leistungshalbleitermoduls teilweise elastisch ausgebildet sind. Unter elastisch ist hier jegliche Ausgestaltung zu verstehen, die eine Kraftübertragung vom Substrat auf die Durchführung der Anschlusselemente durch das Gehäuse verringert oder sogar ausschließt. In einfacher Umsetzung können die Anschlusselement im Inneren des Leistungshalbleitermodul in einem Abschnitt einen mäanderförmigen Verlauf aufweisen.

Für die genannte Leistungshalbleitermodule ist es vorteilhaft, wenn zumindest diejenigen Lastanschlusselemente, die mit Gleichspannung beaufschlagt sind als eine Mehrzahl von Laststromteilelementen mit Laststromteilanschlusselementen gleichen Potentials ausgebildet sind, die jeweils gegeneinander isoliert sind. Weiterhin ist es vorteilhaft, wenn aus eindimensionaler Sicht zwischen zwei Laststromteilanschlusselementen eines Potentials ein Laststromteilanschlusselement eines anderen Potentials, insbesondere im Bereich der Durchführung der Lastanschlusselemente durch das Gehäuse, angeordnet ist. Selbstverständlich gilt analoges auch für die mit Wechselspannung beaufschlagten Lastanschlusselemente.

Das erfindungsgemäße Leistungshalbleitermodul weist somit insbesondere folgende Vorteile auf:
- Einen Schutz des Inneren des Leistungshalbleitermoduls vor typischen Umwelteinflüssen im Betrieb;
- Eine deutliche Verringerung der thermomechanischen Beanspruchungen der Leistungshalbleiterbauelemente;
- Bei Füllung mit Fluid oder Gel eine Kompensierung dessen thermischer Ausdehnung.

Die erfindungsgemäße Anordnung weist ein oben beschriebenes hermetisch dichtes Leistungshalbleitermodul und einer Kühleinrichtung auf, wobei die Kühleinrichtung eine Aufnahme für das Leistungshalbleitermodul aufweist und
a. ausschließlich das Substrat, nicht das Gehäuse, des Leistungshalbleitermoduls in dieser Aufnahme mittels eines ersten Verbindungsmittels elastisch mit der Kühleinrichtung verbunden ist oder
b. ausschließlich das Gehäuse, nicht das Substrat, des Leistungshalbleitermoduls in dieser Aufnahme mittels eines ersten oder zweiten Verbindungsmittels mit der Kühleinrichtung verbunden ist.

Hierbei ist es bevorzugt, wenn die Kühleinrichtung, eine Luftkühleinrichtung, eine Wasserkühleinrichtung oder eine Heatpipe ist.

Ebenso kann es vorteilhaft sein, wenn das zweite Verbindungsmittel eine inelastische Verbindung ausbildet, während das erste Verbindungsmittel eine elastische Verbindung ausbildet.

Es ist weiterhin vorteilhaft, wenn das Leistungshalbleitermodul der Anordnung derart in der Aufnahme der Kühleinrichtung angeordnet ist, dass die Grundplatte des Substrats des Leistungshalbleitermoduls in direktem Kontakt mit dem Kühlmedium der Kühleinrichtung steht.

Es versteht sich, dass die verschiedenen Ausgestaltungen der Erfindung einzeln oder in beliebigen Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung vorteilhafte Einzelheiten und Merkmale ergeben sich aus der nachfolgenden Beschreibung in den Fig. 1 bis 4 dargestellten Ausführungsbeispiele der erfindungsgemäßen Anordnung oder von Teilen hiervon.
Figur 1 zeigt eine erste Ausgestaltung eines erfindungsgemäßen Leistungshalbleitermoduls im seitlichen Schnitt.
Figur 2 zeigt eine Anordnung mit einer zweiten Ausgestaltung eines erfindungsgemäßen Leistungshalbleitermoduls und mit einer Kühlreinrichtung im seitlichen Schnitt.
Figur 3 zeigt eine Anordnung mit einer ersten Ausgestaltung eines erfindungsgemäßen Leistungshalbleitermoduls und mit einer Kühlreinrichtung im seitlichen Schnitt.
Figur 4 zeigt die Draufsicht auf eine weitere Ausgestaltung eines erfindungsmäßen Leistungshalbleitermoduls.

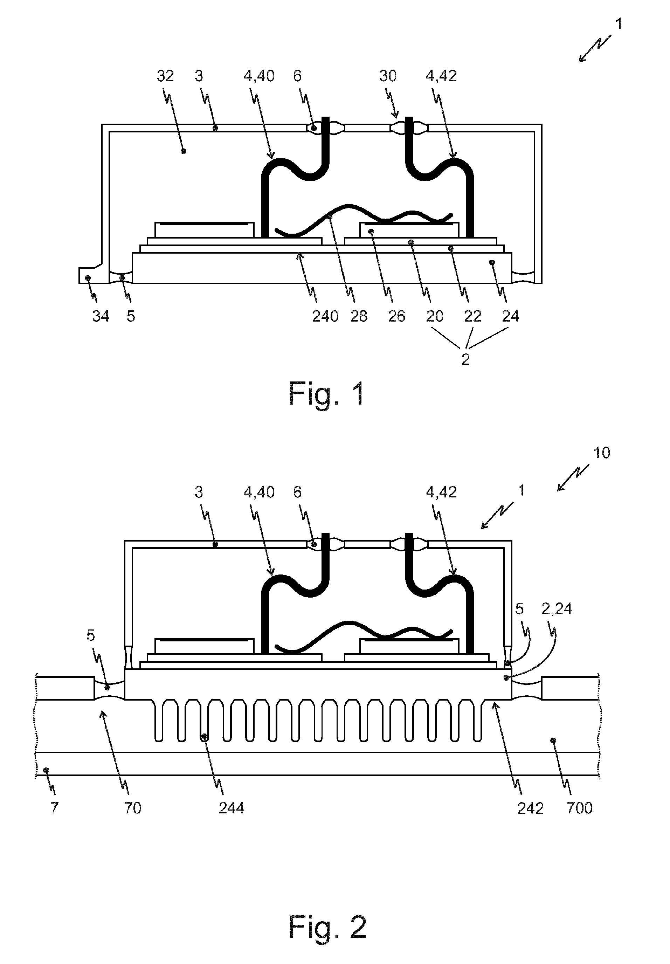

Figur 1 zeigt eine erste Ausgestaltung eines erfindungsgemäßen Leistungshalbleitermoduls 1 im seitlichen Schnitt. Dargestellt ist eine Grundplatte 24 mit einer ersten dem Inneren des Leistungshalbleitermoduls 1 zugewandten Hauptfläche 240. Auf dieser Hauptfläche 240 ist ein Isolierstoffkörper 22 mit Leiterbahnen 20 hierauf angeordnet. Der Isolierstoffkörper 22 ist aus einer Industriekeramik hier Aluminiumoxid ausgebildet, ohne auf diese spezielle Ausgestaltung beschränkt zu sein. Die Leiterbahnen 20 können unterschiedliche Potentiale führen. Auf beiden dargestellten Leiterbahnen 20 sind hier Leistungshalbleiterbauelemente 26 angeordnet. Diese sind in fachüblicher Weise elektrisch leitend mit den Leiterbahnen 20 verbunden.

Fachüblich sind diese Leistungshalbleiterbauelement 26 mit Kontaktflächen ihrer dem Substrat abgewandten Oberseite mit weiteren Leistungshalbleiterbauelementen oder mit Leiterbahnen 20 mittels interner Verbindungseinrichtungen 28 verbunden. Dargestellt ist beispielhaft nur eine derartige interne Verbindungseinrichtung 28, die hier als Drahtbondverbindung ausgebildet ist. Das Substrat 2 mit den Leiterbahnen 20, den Leistungshalbleiterbauelementen 26 und den internen Verbindungseinrichtungen 28 bilden die Schaltung des Leistungshalbleitermoduls 1 aus.

Weiterhin weist das Leistungshalbleitermodul 1 Anschlusselemente 4 auf, die von der Schaltung durch ein Gehäuse 3 des Leistungshalbleitermoduls 1 nach außen reichen und dem externen Anschluss des Leistungshalbleitermoduls dienen.

Diese Anschlusselemente 4 durchdringen das Gehäuse 3 an einer hermetisch dicht ausgebildeten Durchführung 30. Zur Ausbildung dieser hermetisch dichten Durchführung 30 weist das Gehäuses 3 eine Ausnehmung auf, in der das jeweilige Anschlusselement 4 vorzugsweise mittig hindurchragt. Zwischen dem Rand der Ausnehmung und dem zugeordneten Anschlusselement 4 ist hier ein Glaslot angeordnet. Derartig Glaslotdurchführungen sind als solche fachüblich und beispielhaft von Scheibenzellen bekannt.

Das Gehäuse 3 seinerseits besteht hier aus einem isolierenden Werkstoff, konkret einer Industriekeramik. Grundsätzlich ist dies nicht einschränkend, es können auch andere hermetisch dichte Werkstoff für das Gehäuse Verwendung finden. Zur Anordnung des Leistungshalbleitermoduls 1 weist das Gehäuse 3 hier Befestigungseinrichtungen 34 auf, mittels derer das Gehäuse 3 mit einer Kühleinrichtung kraftschlüssig verbunden werden kann. Wesentlich ist hierbei, dass entweder das Gehäuse 3 oder die Grundplatte 24 mit der Kühlrichtung verbunden sind. Eine gleichzeitige kraftschlüssige Verbindung des Gehäuses 3 und der Grundplatte 24 ist erfindungsgemäß zu vermeiden. Es ist bei jeglicher, insbesondere aber bei der Befestigungseinrichtung nach diesem Ausführungsbeispiel, besonders vorteilhaft, wenn die Befestigungseinrichtung nicht starr, beispielhafte mit einer Kühleinrichtung, verbunden ist, sondern wenn die Befestigung vertikal elastisch beweglich und lateral beweglich ausgebildet ist. Diese Beweglichkeit dient dem Ausgleich von beispielhaft thermisch induzierten Kräften auf das Leistungshalbleitermodul, hier konkret auf das Gehäuse. Eine derartige Befestigung kann beispielhaft mittels einer federbelasten Schraubverbindung ausgeführt sein. Alternativ kann die Befestigungseinrichtung 34 elastisch mit Gehäuse verbunden sein.

Erfindungswesentlich ist hier, dass das Gehäuse 3 mit dem Substrat 2 und der darauf angeordneten Schaltung ausschließlich mittels eines ersten elastischen Verbindungsmittels 5 ausgebildet ist, das eine hermetisch dichte Verbindung gestattet. Derartige Verbindungen sind insbesondere keine fachüblichen Klebeverbindungen wie sie in isolierten Leistungshalbleitermodul vielfältig Verwendung finden.

Insbesondere ist das erste elastische Verbindungsmittel 5 zur Ausbildung einer hermetisch dichten Verbindung hier eine Metalllegierung bestehend aus Kupfer und Chrom (CuCr).

Der gesamte Innenraum des Leistungshalbleitermoduls 1 ist mit einem gelartigen Isolierstoff 32 ausgefüllt, wobei auch eine fast vollständige Füllung ausreichend ist. Dieser Isolierstoff 32 kann ein in der Anwendung bei Leistungshalbleitermodulen fachüblicher Silikonkautschuk beliebiger Viskosität sein. Dessen thermische Ausdehnung beim Betrieb des Leistungshalbleitermoduls 1 wird ggf. durch die ersten elastischen Verbindungsmittel 5 ausgeglichen, damit im Innenraum kein der Funktion des Leistungshalbleitermoduls 1 schädlicher Druck besteht.

Die Anschlusselemente 4, 40, 42 sind in ihrer Lage im Gehäuse und an der Schaltung, insbesondere auf den Leiterbahnen 20 fixiert. Damit diese Fixierung an zwei Stellen nicht zu Spannungen führen, die das Leistungshalbleitermodul 1 zumindest im Dauerbetrieb beschädigen können, sind die Anschlusselemente 4, 40, 42 in ihrem Verlauf teilweise elastisch, hier durch Einbringen einer Mäanderstruktur, ausgebildet.

Figur 2 zeigt eine Anordnung mit einer zweiten Ausgestaltung eines erfindungsgemäßen Leistungshalbleitermoduls 1 und mit einer Kühlreinrichtung 7 im seitlichen Schnitt. Das Leistungshalbleitermodul 1 entspricht im Wesentlichen demjenigen der ersten Ausgestaltung mit folgenden beiden Unterschieden:
Bei der zweiten Ausgestaltung ist das erste Verbindungsmittel 5 und dessen Kontaktflächen mit der Grundplatte 24 und dem Gehäuse 3 nicht in einer Ebene parallel zur ersten Hauptfläche der Grundplatte 24 angeordnet. Vielmehr sind hier das erste Verbindungsmittel 5 und dessen Kontaktflächen mit der Grundplatte 24 und dem Gehäuse 3 orthogonalen zu dieser Ebene angeordnet.

Die Grundplatte 24 weist bei der zweiten Ausgestaltung des Leistungshalbleitermoduls auf ihrer dem Modulinneren abgewandten Seite 242 Kühlelemente 244, hier speziell Kühlfinger, auf.

Erfindungsgemäß ist das Leistungshalbleitermodul 1 in einer Ausnehmung 70 der Kühleinrichtung 7 angeordnet. Die Grundplatte 24 ist mittels erster elastischer Verbindungsmittel 5 mit der Kühlreinrichtung 7 verbunden. Somit ist sichergestellt, dass die Grundplatte 24 und damit die Schaltung des Leistungshalbleitermoduls 1 mechanisch derart von der Einwirkung äußerer Kraft, beispielhaft hervorgerufen durch die Kühleinrichtung 7, entkoppelt ist. Somit führt thermische Ausdehnung im Betrieb nicht zu schädigenden Einwirkungen auf die Schaltungselemente.

Die Kühleinrichtung 7 selbst ist dazu ausgebildet mit einer Kühlflüssigkeit 700 durchströmt zu werden und hierbei mittels der Kühlfinger 244 der Grundplatte 24 die Leistungshalbleiterbauelemente 26 zu kühlen.

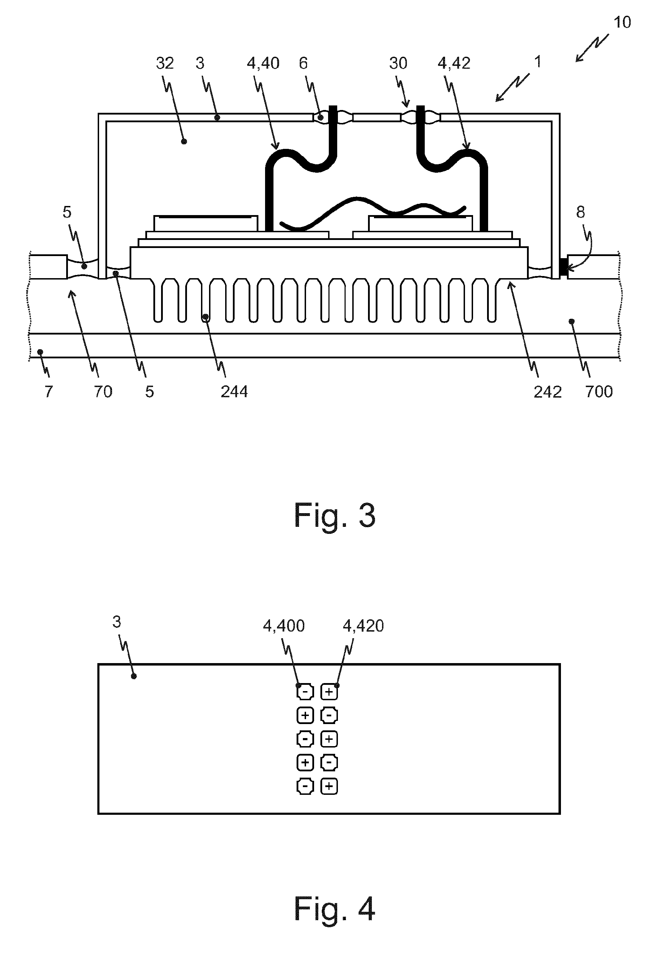

Figur 3 zeigt eine Anordnung mit einer ersten Ausgestaltung eines erfindungsgemäßen Leistungshalbleitermoduls 1 und mit einer Kühlreinrichtung 7 im seitlichen Schnitt.

Hierbei ist die Grundplatte 24 mittels erster elastischer Verbindungsmittel 5 mit dem Gehäuse 3 verbunden, während dieses vorzugsweise mittels erster elastischer Verbindungsmittel 5 oder auch mittels zweiter inelastischer Verbindungsmittel mit 8 der Kühlreinrichtung 7 verbunden ist. Somit ist hier ebenfalls die Einwirkung einer äußeren Kraft auf die Schaltungselemente wirksam verhindert.

Figur 4 zeigt die Draufsicht auf eine weitere Ausgestaltung eines erfindungsmäßen Leistungshalbleitermoduls 1. Da derartige Leistungshalbleitermodule eine besonders hohe Leistungsdichte aufweisen können, sind insbesondere der externen elektrischen Lastanschlüsse entsprechend auszubilden. Hierbei sind die diejenigen Lastanschlusselemente 40, 42, die mit Gleichspannung beaufschlagt sind als eine Mehrzahl von Laststromteilelementen mit Laststromteilanschlusselementen 400, 420 gleichen Potentials ausgebildet sind, die gegeneinander isoliert sind.

Weiterhin sind in eindimensionaler Sicht aus beiden orthogonalen Richtungen zwischen zwei Laststromteilanschlusselementen 400 eines Potentials ein Laststromteilanschlusselement 420 eines anderen Potentials angeordnet. Dies ist hier sinngemäß in einer Richtung nur durch einen Versatz der Laststromteilanschlusselement 420, 422 unterschiedlicher Polarität erfolgt.

## Patentansprüche

1. Hermetisch dichtes Leistungshalbleitermodul (1) mit einem Substrat (2), einem Gehäuse (3) und Anschlusselementen (4) für Last- (40) und Hilfsanschlüsse, wobei das Substrat (2) eine metallische Grundplatte (24) aufweist auf deren dem Modulinneren zugewandten Hauptfläche (240) ein Isolierstoffkörper (22) mit Leiterbahnen (20) und mindestens einem hierauf angeordneten Leistungshalbleiterbauelement (26) sowie modulinterne Verbindungseinrichtungen (28) angeordnet sind;
wobei das Gehäuse (3) aus einem hermetisch dichten Werkstoff ausgebildet ist und mit dem Substrat (2) mittels eines elastischen, hermetisch dicht schließenden ersten Verbindungsmittels (5) verbunden ist;
und wobei die Last- (40) und Hilfsanschlusselemente von der leistungselektrischen Schaltung des Substrats (2) nach außen durch das Gehäuse (3) führen und diese Durchführung (30) hermetisch dicht ausgebildet ist.

2. Leistungshalbleitermodul nach Anspruch 1, wobei
die Grundplatte (24) auf ihrer dem modulinneren abgewandten Seite (242) Kühlelemente (244), insbesondere Kühlfinger oder Kühlfinnen, aufweist.

3. Leistungshalbleitermodul nach Anspruch 1, wobei
die Anschlusselemente in Ihrem Verlauf im Innenraum des Leistungshalbleitermoduls teilweise elastisch ausgebildet sind.

4. Leistungshalbleitermodul nach Anspruch 1, wobei
das Gehäuse (3) aus Metall, aus Keramik oder aus Glaskeramik oder geeigneten Kombinationen hieraus ausgebildet ist.

5. Leistungshalbleitermodul nach Anspruch 1, wobei
das erste elastische Verbindungsmittel (5) aus einem Material hoher Biegezyklenfestigkeit (z.B. CuCr etc) besteht und dieses insbesondere mit einem Schutzüberzug beschichtet ist.

6. Leistungshalbleitermodul nach Anspruch 1, wobei
der gesamte Innenraum (32) mittels eines Isolierstoffes in flüssiger oder gelartiger Ausgestaltung ausgefüllt ist.

7. Leistungshalbleitermodul nach Anspruch 1, wobei
die Durchführung (30) der Last- und Hilfsanschlusselemente als Glaslotdurchführung (6) ausgebildet ist.

8. Leistungshalbleitermodul nach Anspruch 1, wobei
zumindest diejenigen Lastanschlusselemente (40), die mit Gleichspannung beaufschlagt sind als eine Mehrzahl von Laststromteilelementen mit Laststromteilanschlusselementen (400, 420) gleichen Potentials ausgebildet sind, die gegeneinander isoliert sind.

9. Leistungshalbleitermodul nach Anspruch 8, wobei
in eindimensionaler Sicht zwischen zwei Laststromteilanschlusselementen (400) eines Potentials ein Laststromteilanschlusselement (420) eines anderen Potentials angeordnet ist.

10. Anordnung (10) mit einem hermetisch dichten Leistungshalbleitermodul (1) gemäß vorhergehender Ansprüche und einer Kühleinrichtung (7), wobei die Kühleinrichtung eine Aufnahme (70) für das Leistungshalbleitermodul (1) aufweist und
a. ausschließlich das Substrat (2), nicht das Gehäuse (3), des Leistungshalbleitermoduls (1) in dieser Aufnahme (70) mittels eines ersten Verbindungsmittels (5) elastisch mit der Kühleinrichtung (7) verbunden ist oder
b. ausschließlich das Gehäuse (3), nicht das Substrat (2), des Leistungshalbleitermoduls (1) in dieser Aufnahme mittels eines ersten (5) oder zweiten Verbindungsmittels (8) mit der Kühleinrichtung verbunden ist.

11. Anordnung nach Anspruch 10, wobei
die Kühleinrichtung (7), eine Luftkühleinrichtung, eine Wasserkühleinrichtung oder eine Heatpipe ist.

12. Anordnung nach Anspruch 10, wobei
das zweite Verbindungsmittel (8) eine inelastische Verbindung ausbildet.

13. Anordnung nach Anspruch 10, wobei
das Leistungshalbleitermodul (1) derart in der Aufnahme (70) der Kühleinrichtung (7) angeordnet ist, dass die Grundplatte (24) des Substrats (2) des Leistungshalbleitermoduls (1) in direktem Kontakt mit dem Kühlmedium (700) der Kühleinrichtung (7) steht.
